# EUROPÄISCHE PATENTSCHRIFT

(11) **EP 1 123 644 B1**
(45) Veröffentlichungstag und Bekanntmachung des Hinweises auf die Patenterteilung: **21.04.2004**
(21) Anmeldenummer: 99969574.5
(22) Anmeldetag: 09.09.1999
(51) Int. Cl.: H05K 3/46

(54) **VERFAHREN ZUR HERSTELLUNG VON MEHRLAGENSCHALTUNGEN**
METHOD FOR PRODUCING MULTI-LAYER CIRCUITS
PROCEDE DE PRODUCTION DE CIRCUITS MULTICOUCHES

(30) Priorität: 18.09.1998 CH 191198
(43) Veröffentlichungstag der Anmeldung: 16.08.2001
(73) Patentinhaber: Vantico AG, 4057 Basel (CH)
(72) Erfinder: MEIER, Kurt, CH-4106 Therwil (CH); MÜNZEL, Norbert, D-79423 Heitersheim (DE)
(74) Vertreter: Dannappel, Hans-Jochen, Dr.
(86) Internationale Anmeldenummer: PCT/EP1999/006630
(87) Internationale Veröffentlichungsnummer: WO 2000/018201

(56) Entgegenhaltungen:
- DE-A- 3 840 207
- US-A- 5 451 721
- Y. TSUKADA ET AL.: "Surface Laminar Circuit Packaging" PROCEEDINGS OF THE 42ND ELECTRONIC COMPONENTS & TECHNOLOGY CONFERENCE, 18-20 MAI 1992, SAN DIEGO, CALIFORNIA, US,1992, Seiten 22-27, XP000473962 IEEE

## Beschreibung

Die vorliegende Erfindung betrifft ein Verfahren zur Herstellung von mehrschichtigen Leiterplatten.

Mehrschichtige Leiterplatten mit hoher Verdrahtungsdichte werden in letzter Zeit vorteilhaft nach dem sogenannten SBU-Verfahren ("sequential build-up") hergestellt.
Die elektrische Verbindung zwischen den einzelnen Leiterbahnen (" Durchkontaktierungen") wird üblicherweise mittels gebohrter Löcher hergestellt, die die Leiterbahnebenen durchdringen und metallisiert werden. Die mechanisch gebohrten Löcher sind jedoch relativ groß (Mindestdurchmesser ca. 0,3 mm) und schränken die Verdrahtungsdichte der Leiterplatte ein.
In der DE-A 38 40 207 wird ein Verfahren zur Herstellung von mehrschichtigen Leiterplatten beschrieben, worin Durchkontaktierungen mit niedrigem Durchmesser photochemisch mit Hilfe von Photoresistmaterialien hergestellt werden.
Auch das US-Patent 5,451,721 schlägt ein SBU-Verfahren vor, worin zunächst Durchkontaktierungen zwischen den einzelnen Leiterbahnebenen unter Verwendung von Photoresists angebracht werden. Anschließend wird durch mechanisch gebohrte und metallisierte Durchgangslöcher eine leitende Verbindung zwischen den äußersten Verdrahtungsschichten hergestellt. In der so hergestellten Leiterplatte dienen die beiden äußeren Verdrahtungsschichten als Leistungsversorgungsleitungen, während sich die Signalverdrahtungsleitungen im Innem des Laminats befinden.
Allerdings ist das im US-Patent 5,451,721 beschriebene Verfahren zur Herstellung von Leiterplatten mit ungleicher Anzahl Verdrahtungsschichten auf beiden Seiten des Laminatkem nur bedingt geeignet, da man bei der Ausführungsform mit unsymmetrischem Aufbau eine starke Verwölbung, insbesondere bei Verwendung von Laminatkemen mit einer Dicke von kleiner als 0,8 mm, aufgrund von Polymerisationsschrumpf der nur einseitig aufgebrachten Dielektrikumsschicht in Kauf nehmen muß. Außerdem führt die ein- bzw. mehrmalige Verkupferung der rückseitigen Kupferschicht zu unterschiedlichen Kupferdicken auf beiden Seiten der Platte. Das anschließende üblicherweise durchgeführte gleichzeitige Ätzen beider Seiten führt zu einer Überätzung auf der oberen dünneren Kupferschicht.

Aufgabe der Erfindung war es, ein Verfahren zur Herstellung von sequentiell aufgebauten Leiterplatten mit ungleicher Anzahl Leitungsebenen auf beiden Seiten des Laminatkems zu entwickeln, das die oben angegebenen Nachteile nicht aufweist.

Es wurde nun gefunden, daß zufriedenstellende Resultate erzielt werden, wenn man von einem Laminatkem ausgeht, der nur auf einer Seite Leiterstrukturen aufweist, diesen beidseitig mit einem Dielektrikum beschichtet, jedoch nur eine Seite strukturiert und die andere Seite vollständig aushärtet.

Gegenstand der vorliegenden Erfindung ist somit ein Verfahren zur Herstellung von sequentiell aufgebauten Leiterplatten mit ungleicher Anzahl Leitungsebenen auf beiden Seiten eines Laminatkerns welches die im Anspruch 1 definierten Verfahrensschritte umfaßt.

Die Erfindung wird durch die zugehörigen Zeichnungen veranschaulicht.

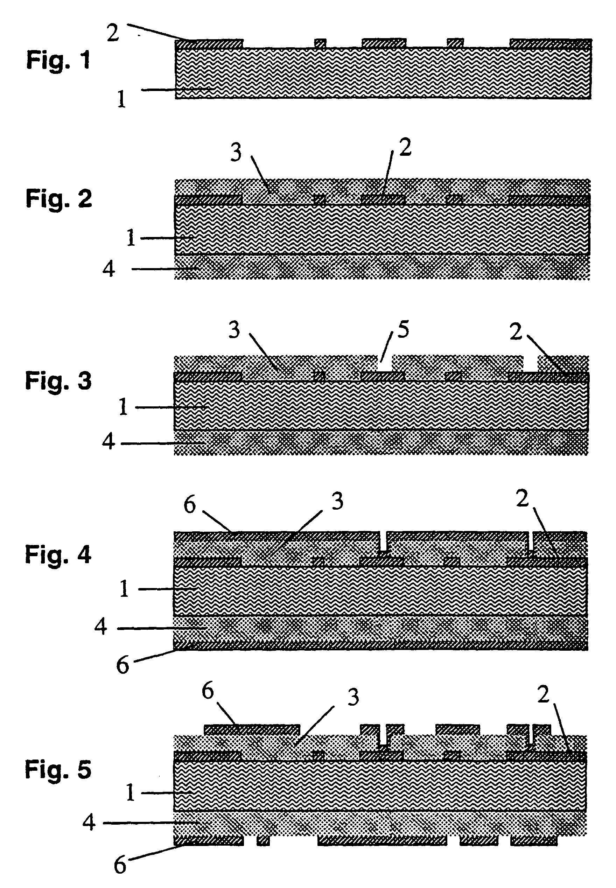

Figur 1 zeigt ein isolierendes Substrat (1), vorzugsweise ein glasfaserverstärktes Epoxidharz, das nur auf einer Seite Leiterstrukturen (2) aufweist.

Im Verfahrensschritt (A) wird diese einseitige Leiterplatte auf beiden Seiten mit einem dielektrischen härtbaren Material (3 und 4, Fig. 2) beschichtet.
Die Beschichtung wird mit den üblichen Methoden durchgeführt, z.B. durch Schleudern, Tauchen, Rakelbeschichtung, Vorhangguß, Siebdruck, Aufpinseln, Sprühen, Elektrostatisches Sprühen oder Reverse Rollbeschichtung.

Vorzugsweise wird die Leiterplatte mittels Vorhangguß oder Siebdruck beschichtet.

Das dielektrische Material kann als Lösung oder auch als Trockenfilm aufgebracht werden. Bei Verwendung einer Lösung wird das Lösungsmittel anschließend durch Trocknen entfernt. Die Schichtdicke des Dielektrikums muß höher sein als die Höhe der Kupferleiterzüge der Leiterplatte. Die Trockenschicht ist zweckmäßig etwa 20-150 µm, bevorzugt 30-80 µm, dick.

Als dielektrisches Material kann sowohl ein Photopolymer (Photovia-Prozeß) als auch ein thermisch härtbares Polymer (Laservia-Prozeß) eingesetzt werden.
Im Photovia-Prozeß können sowohl Positiv-Photoresists als auch Negativ-Photoresists Anwendung finden.
Geeignete Photoresistmaterialien sind dem Fachmann bekannt.
Beispiele dafür sind die in der EP-A 689 098 beschriebenen Positiv-Photoresists und die aus der EP-A 605 361 bekannten Negativ-Photoresists.

Die im Verfahrensschritt (A) eingesetzte Leiterplatte kann bereits eine konventionelle Mehrlagenschaltung sein, deren Durchkontaktierungslöcher noch nicht gebohrt sind oder deren gebohrte Durchkontaktierungslöcher mit einem Harz verschlossen worden sind.

Im Verfahrensschritt (B) (Fig. 3) wird auf der Seite mit den Leiterstrukturen mit Hilfe bildgebender Verfahren das Dielektrikum an den für die Durchkontaktierungslöcher vorgesehenen Stellen (5) entfernt.
Beim Photovia-Prozeß wird die Photoresist-Beschichtung durch eine der aufzubringenden Leiterbahnen-Struktur entsprechende Maske belichtet und entwickelt. Um eine vollständige Vernetzung zu erreichen, empfiehlt sich im Anschluß an den Verfahrensschritt (B) eine thermische Nachhärtung.

Bei Verwendung eines negativ arbeitenden Photo-Via-Dielektrikums wird vorzugsweise vor oder nach der thermischen Nachhärtung zusätzlich eine beidseitige vollflächige Belichtung vorgenommen.

Auf der Rückseite der Leiterplatte wird das dielektrische Material ohne vorherige Strukturierung auf der ganzen Fläche vollständig ausgehärtet.
Dies geschieht im Falle eines Negativ-Photoresists durch vollflächige Belichtung und gegebenenfalls thermische Nachhärtung. Bei einem Positiv-Photoresist wird die Leiterplattenrückseite ohne vorherige Belichtung vollflächig thermisch ausgehärtet.

Falls keine zusätzlichen Leitungsebenen benötigt werden und noch keine Durchkontaktierungen zwischen Vorder- und Rückseite der Leiterplatte vorhanden sind, können die Durchkontaktierungen nach Ausführung des Verfahrensschritts (B) durch Bohrungen vorbereitet werden.

Die so erhaltene Leiterplatte wird auf beiden Seiten durch Ätzen nach bekannten Verfahren (beispielsweise mit wäßriger KMnO₄-Lösung) aufgerauht. Anschließend wird die gesamte Oberfläche chemisch verkupfert (Fig. 4), d.h. durch stromloses Plattieren wird eine dünne Kupferschicht (6) aufgebracht. Gegebenenfalls wird nachgetrocknet und die Kupferschicht durch galvanische Abscheidung verstärkt.

Im Verfahrensschritt (D) wird die Kupferschicht dann auf beiden Seiten durch selektives Ätzen strukturiert (Fig. 5), im allgemeinen durch beidseitige Beschichtung der Leiterplatte mit einem Ätzresist, bildmäßiges Belichten, Entwickeln und Entfernen des freigelegten Kupfers.
Dies kann in einem Ätzprozeß ("panel plating process") oder im Galvanoprozeß ("pattern plating process") erfolgen.

Falls zusätzliche Leiterebenen benötigt werden, können die Verfahrensschritte (A) bis (D) beliebig oft wiederholt werden.

## Patentansprüche

1. Verfahren zur Herstellung von sequentiell aufgebauten Leiterplatten mit ungleicher Anzahl Leitungsebenen auf beiden Seiten eines Laminatkerns (1), welches die folgenden Verfahrensschritte umfasst:
(A) beidseitiges Beschichten einer eine Vorder-und eine Rückseite aufweisenden Leiterplatte, die nur auf der Vorderseite Leiterstrukturen (2) aufweist, mit einem Dielektrikum (3, 4) enthaltend ein Photopolymer oder ein thermisch härtbares Polymer, wobei die Schichtdicke des Dielektrikums höher sein muss als die Höhe der Kupferleiterzüge der Leiterplatte;
(B) Strukturierung von Kontaktierungslöchern (5) auf der Vorderseite mit den Leiterstrukturen (2) durch Belichtung des Dielektrikums (3) enthaltend ein Photopolymer und anschließende Entwicklung mit einem Lösungsmittel oder durch Laser-Bohren der Kontaktierungslöcher in das Dielektrikum (3) enthaltend ein thermisch härtbares Polymer;
(C) Abscheiden einer Kupferschicht (6) auf beiden Seiten der so erhaltenen Platte;
(D) Bildung von Leiterstrukturen auf der Vorderseite und vollständiges Wegätzen der Kupferschicht auf der Rückseite, falls ein weiterer asymmetrischer Aufbau erfolgt, oder auf beiden Seiten der Leiterplatte bei keinem bzw. einem symmetrischen Weiteraufbau, durch selektives Ätzen mit Hilfe von Resists;
(E) Wiederholung der Prozeßschritte (A) bis (D), wobei im Prozeßschritt (B) die Strukturierung von Kontaktierungslöchem auf beiden Seiten durchgeführt wird, falls ein weiterer symmetrischer Aufbau erfolgt.

2. Verfahren nach Anspruch 1, **dadurch gekennzeichnet, daß** im Verfahrensschritt (A) die Leiterplatte mittels Vorhangguß oder Siebdruck beschichtet wird.

3. Verfahren nach Anspruch 1, **dadurch gekennzeichnet, daß** beim Photo-Via-Prozeß im Anschluß an den Verfahrensschritt (B) eine thermische Nachhärtung zur vollständigen Vernetzung des Polymeren vorgenommen wird.

4. Verfahren nach Anspruch 3, **dadurch gekennzeichnet, daß** bei Verwendung eines negativ arbeitenden Photo-Via-Dielektrikums nach dem Verfahrensschritt (B) eine beidseitige vollflächige Belichtung vor oder nach der thermischen Nachhärtung zur vollständigen Vernetzung des Polymeren vorgenommen wird.

5. Verfahren nach Anspruch 1, **dadurch gekennzeichnet, daß** im Verfahrensschritt (C) die Platte zunächst aufgerauht, dann chemisch verkupfert und anschließend galvanisch verkupfert wird.

6. Verfahren nach Anspruch 1, **dadurch gekennzeichnet, daß** nach dem Verfahrensschritt (B) Durchgangslöcher in die Leiterplatte gebohrt werden.

## Claims

1. A method for producing sequentially built-up printed circuit boards having a disparate number of conduction planes on both sides of a laminate core (1), which method comprises the following method steps:
(A) coating both sides of a printed circuit board having a front and a back side and having conductor structures (2) on only one side with a dielectric (3,4) comprising a photopolymer or a thermally curable polymer, whereby the coating thickness of the dielectric must be greater than the height of the copper conductor tracks of the printed circuit board;
(B) structuring the plating holes (5) on the front side having the conductor structures (2) by exposing the dielectric (3) comprising a photopolymer to light and then developing with a solvent or by laser-drilling the plating holes into the dielectric (3) comprising a thermally cured polymer;
(C) depositing a copper layer (6) on both sides of the board so obtained;
(D) forming conductor structures on the front and completely etching away of the copper layer on the back side, if further asymmetric build-up is to be carried out, or on both sides of the printed circuit board if there is to be no further build-up or if further build-up is to be carried out symmetrically, by means of selective etching with the aid of resists;
(E) repetition of process steps (A) to (D), whereby in process step (B) the structuring of the plating holes is carried out on both sides, if further build-up is to be carried out symmetrically.

2. A method according to claim 1, wherein in method step (A) the printed circuit board is coated by means of curtain pouring or screen-printing.

3. A method according to claim 1, wherein in the photo-via process, after method step (B), thermal after-curing is carried out for completely crosslinking the polymer.

4. A method according to claim 3, wherein, when a negative photo-via dielectric is used, full-area exposure of both sides to light is carried out after method step (B), before or after thermal after-curing for completely crosslinking the polymer.

5. A method according to claim 1, wherein in method step (C) the board is first roughened and then chemically copper-plated and subsequently copper-plated by electrodeposition.

6. A method according to claim 1, wherein through-holes are drilled into the printed circuit board after method step (B).

## Revendications

1. Procédé de fabrication de plaquettes de circuits imprimés construites de façon séquentielle avec un nombre inégal de niveaux conducteurs des deux côtés d'un coeur stratifié (1), lequel comprend les étapes de procédé suivantes :
(A) revêtement, sur ses deux faces, d'une plaquette de circuits imprimés comprenant une face avant et une face arrière, qui comporte des structures conductrices (2) seulement sur la face avant, avec un diélectrique (3, 4) contenant un photopolymère ou un polymère thermodurcissable, sachant que l'épaisseur de la couche de diélectrique doit être plus grande que la hauteur des pistes conductrices en cuivre de la plaquette de circuits imprimés ;
(B) structuration de trous de contact (5) sur la face avant avec les structures conductrices (2) par éclairement du diélectrique (3) contenant un photopolymère, et un développement ultérieur avec un solvant ou par une perceuse laser des trous de contact dans le diélectrique (3) contenant un polymère thermodurcissable ;
(C) déposition d'une couche de cuivre (6) sur les deux faces de la plaque ainsi obtenue ;
(D) formation de structures conductrices sur la face avant par gravure sélective à l'aide de resists et gravure totale de la couche de cuivre sur la face arrière, dans le cas où une construction asymétrique ultérieure a lieu, ou des deux côtés de la plaquette de circuits imprimés si ce n'est pas le cas, ou encore si une construction symétrique ultérieure a lieu ;
(E) répétition des étapes de procédé (A) à (D), sachant que, dans l'étape de procédé (B), la structuration des trous de contact est exécutée sur les deux faces au cas où une construction symétrique ultérieure a lieu.

2. Procédé selon la revendication 1, **caractérisé en ce que**, dans l'étape de procédé (A), la plaquette de circuits imprimés est recouverte par coulage en rideau ou sérigraphie.

3. Procédé selon la revendication 1, **caractérisé en ce que**, dans le procédé en mode photosensible, à la suite de l'étape de procédé (B), un durcissement thermique est entrepris pour réticuler totalement le polymère.

4. Procédé selon la revendication 3, **caractérisé en ce que**, lors de l'utilisation d'un diélectrique en mode photosensible fonctionnant en négatif selon l'étape de procédé (B), un éclairement sur les deux faces et sur toute la surface est entrepris avant ou après le durcissement thermique pour réticuler totalement le polymère.

5. Procédé selon la revendication 1, **caractérisé en ce que**, dans l'étape de procédé (C), la plaque est d'abord rendue rugueuse, ensuite cuivrée chimiquement et ensuite cuivrée par galvanisation.

6. Procédé selon la revendication 1, **caractérisé en ce que**, après l'étape de procédé (B), les trous de passage sont percés dans la plaquette de circuits imprimés.
